(19)

**Europäisches Patentamt**
**European Patent Office**
**Office européen des brevets**

(11) **EP 4 632 785 A1**

(12) **EUROPEAN PATENT APPLICATION**
published in accordance with Art. 153(4) EPC

(43) Date of publication:
**15.10.2025 Bulletin 2025/42**

(21) Application number: **23899369.5**

(22) Date of filing: **27.06.2023**

(51) International Patent Classification (IPC):
*H01J 37/147* (2006.01)   *H01J 37/30* (2006.01)

(52) Cooperative Patent Classification (CPC):
**H01J 37/147; H01J 37/30**

(86) International application number:
**PCT/CN2023/102689**

(87) International publication number:
**WO 2024/119782 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.12.2022 CN 202211558339**

(71) Applicant: **Jiangsu Leuven Instruments Co. Ltd**
**Xuzhou, Jiangsu 221300 (CN)**

(72) Inventors:
• **YANG, Zhen**
**Xuzhou, Jiangsu 221300 (CN)**
• **HU, Dongdong**
**Xuzhou, Jiangsu 221300 (CN)**

• **HE, Xiaoming**
**Xuzhou, Jiangsu 221300 (CN)**
• **YAN, Kuicheng**
**Xuzhou, Jiangsu 221300 (CN)**
• **CHEN, Longbao**
**Xuzhou, Jiangsu 221300 (CN)**
• **LI, Xuedong**
**Xuzhou, Jiangsu 221300 (CN)**
• **HU, Jie**
**Xuzhou, Jiangsu 221300 (CN)**
• **ZOU, Bo**
**Xuzhou, Jiangsu 221300 (CN)**
• **XU, Kaidong**
**Xuzhou, Jiangsu 221300 (CN)**

(74) Representative: **Eisenführ Speiser**
**Patentanwälte Rechtsanwälte PartGmbB**
**Postfach 10 60 78**
**28060 Bremen (DE)**

(54) **ION GRID STRUCTURE IN ION BEAM ETCHING**

(57)    The present application provides an ion grid structure in ion beam etching, comprising: a screen grid and at least one grid located on the side of the screen grid away from a discharge chamber. The screen grid is in contact with a dielectric; at least one of the grids is in contact with the dielectric. According to the present application, the dielectric is provided as the grid skeleton of the ion grid structure, so that the mechanical strength of the grids is borne by the dielectric, thereby improving the mechanical strength of the ion grid structure, and enhancing the stability and reliability of the ion grid structure.

**FIG. 5**

EP 4 632 785 A1

## Description

This application claims the priority to Chinese Patent Application No.202211558339.4, titled "ION GRID STRUCTURE IN ION BEAM ETCHING", filed on December 6, 2022 with the China National Intellectual Property Administration, which is incorporated herein by reference in its entirety.

## FIELD

The present disclosure relates to the technical field of semiconductors, and in particular to an ion grid structure for ion beam etching.

## BACKGROUND

In the semiconductor industry, various semiconductor devices such as sensors and memory devices are increasingly adopting ion beam etching (IBE) systems in their manufacturing processes, with some processes even relying on IBE.

The operating principle of IBE is as follows. Process gases inside the ion source chamber are excited by radio-frequency electromagnetic waves under low-pressure conditions to generate plasma. Ions within the plasma are extracted and accelerated by an ion grid. Electrons generated by a neutralizer are combined with the ions in the ion beam to form neutral particles. The particle beam reaches a surface of a substrate, and physical etching is achieved through the bombardment of the accelerated particles.

How to improve the reliability and stability of an ion grid structure for ion beam etching is a technical problem to be addressed in the field.

## SUMMARY

In view of this, concepts of the present disclosure are briefly described in summary and detailed in embodiments. The summary is not intended to define key or essential features of the claimed technical solution, nor is it intended to determine the scope of the claimed technical solution.

The objective of the present disclosure is to provide an ion grid structure for ion beam etching, to improve intensity of an ion beam extracted through a grid and improve efficiency of the ion beam etching.

Technical solutions provided to achieve the forgoing objective according to the present disclosure are described below.

An ion grid structure for ion beam etching is provided according to an embodiment of the present disclosure. The ion grid structure includes a screen grid and one or more grids. The one or more grids are arranged on a side of the screen grid away from a discharge chamber. The screen grid is in contact with a dielectric. At least one grid of the one or more grids is in contact with the dielectric.

In an embodiment, the one or more grids include an acceleration grid arranged on a side of the screen grid away from the discharge chamber.

In an embodiment, a distance between the screen grid and the acceleration grid is less than or equal to a first preset threshold, and a thickness of the screen grid is less than or equal to a second preset threshold.

In an embodiment, the one or more grids include a deceleration grid arranged on a side of the acceleration grid away from the screen grid.

In an embodiment, the one or more grids include an extraction grid arranged between the screen grid and the acceleration grid.

In an embodiment, the one or more grids include a focus grid arranged between the extraction grid and the acceleration grid.

In an embodiment, the dielectric arranged on a same side of the grid is provided with at least one type.

In an embodiment, the dielectric arranged on different sides of the grid is provided with at least one type.

In an embodiment, the acceleration grid is arranged inside the dielectric.

In an embodiment, the dielectric is made of a material with a breakdown voltage greater than or equal to a third preset threshold.

In an embodiment, the dielectric is made of an insulation material.

In an embodiment, a mechanical strength of the dielectric is greater than or equal to a fourth preset threshold.

In an embodiment, the first preset threshold is 3mm and the second preset threshold is 5mm.

In an embodiment, a material of the dielectric includes alumina, aluminum nitride and/or quartz.

In an embodiment, the third preset threshold is 0.1kV/mm.

In an embodiment, an ion beam current extracted through a single aperture of the ion grid structure is expressed as:

$$I1 = \frac{4\pi\varepsilon_0}{9}\sqrt{\frac{2e}{M}}V^{\frac{3}{2}}\frac{1}{1+4(\frac{l_g+t_s}{d_s})^2}$$

where I1 represents the ion beam current extracted through the single aperture of the ion grid structure, $\varepsilon_0$ represents a dielectric constant in vacuum, e represents a charge number of an ion beam, M represents an atomic mass of the ion beam, V represents an extraction voltage, $l_g$ represents a distance between the screen grid and the acceleration grid, $t_s$ represents a thickness of the screen grid, and $d_s$ represents an aperture of the screen grid.

In an embodiment, the screen grid and the one or more grids are made of electrically conductive materials.

In an embodiment, electrical conductivity of the screen grid and the one or more grids is greater than a first preset value.

In an embodiment, hardness of the screen grid and the one or more grids is greater than a second preset value.

In an embodiment, thermal expansion coefficients of the screen grid and the one or more grids are less than a third preset value.

In an embodiment, a material of the screen grid includes molybdenum or graphite.

In an embodiment, a positive voltage is applied to the screen grid and a negative voltage is applied to the acceleration grid.

In an embodiment, the deceleration grid is grounded.

In an embodiment, a voltage of the extraction grid is less than a voltage of the screen grid and greater than a voltage of the acceleration grid.

In an embodiment, a voltage of the focus grid is less than a voltage of the extraction grid and greater than a voltage of the acceleration grid.

Compared with the conventional technology, embodiments of the present disclosure have the following beneficial effects.

An ion grid structure for ion beam etching is provided according to the embodiments of the present disclosure. The ion grid structure includes a screen grid and one or more grids arranged on a side of the screen grid away from a discharge chamber. The screen grid is in contact with a dielectric, and at least one of the grids is in contact with the dielectric. According to the present disclosure, the dielectric is configured as a grid framework of the ion grid structure, so that the mechanical strength of the grid is borne by the dielectric, thereby improving the mechanical strength of the ion grid structure and enhancing the stability and reliability of the ion grid structure.

## BRIEF DESCRIPTION OF THE DRAWINGS

In order to more clearly describe technical solutions in embodiments of the present disclosure or the technical solutions in the conventional technology, drawings to be used in the description of the embodiments of the present disclosure or the conventional technology are briefly described hereinafter. It is apparent that the drawings described below illustrate merely some embodiments of the present disclosure, and those skilled in the art may obtain other drawings based on the provided drawings without any creative effort.

The above and other features, advantages, and aspects of embodiments of the present disclosure become more apparent when taken in conjunction with accompanying drawings and with reference to the following embodiments. Same or similar numerals throughout the drawings represent same or similar elements. It should be understood that the drawings are schematic, and components and elements are not necessarily drawn to scale.

FIG. 1 is a schematic diagram of an ion source discharge structure according to the conventional technology;

FIG. 2 is a schematic diagram of density distribution of extracted ion beams according to the conventional technology;

FIG. 3 is a schematic diagram of an ion grid structure for ion beam etching according to the conventional technology;

FIG. 4 is a schematic diagram of key parameters of an ion grid structure for ion beam etching according to the conventional technology; and

FIG. 5 is a schematic diagram of key parameters of an ion grid structure for ion beam etching according to an embodiment of the present disclosure.

## DETAILED DESCRIPTION

In order to make the above objectives, features, and advantages of the present disclosure more apparent and easier to understand, embodiments of the present disclosure are described in detail below in conjunction with the drawings and the embodiments.

Various details are set forth in following description to facilitate a full understanding of the present disclosure. The present disclosure may be implemented in a manner different from those described herein, and those skilled in the art may perform analogous promotion without departing from concepts of the present disclosure. Therefore, the present disclosure is not limited by the embodiments disclosed hereinafter.

As described in the background, in the semiconductor industry, various semiconductor devices such as sensors and memory devices are increasingly adopting ion beam etching (IBE) systems in their manufacturing processes, with some processes even relying on IBE.

The operating principle of IBE is as follows. Process gases inside the ion source chamber are excited by radio-frequency electromagnetic waves under low-pressure conditions to generate plasma. Ions within the plasma are extracted and accelerated by an ion grid. Electrons generated by a neutralizer are combined with the ions in the ion beam to form neutral particles. The particle beam reaches a surface of a substrate, and physical etching is achieved through the bombardment of the accelerated particles.

How to enhance the intensity of the ion beam extracted through the grid to improve efficiency of the ion beam etching is a technical problem to be addressed in the field.

To solve the above technical problem, an ion grid structure for ion beam etching is provided according to embodiments of the present disclosure. The ion grid structure includes a screen grid and one or more grids arranged on a side of the screen grid away from a discharge chamber. The screen grid is in contact with a dielectric, and at least one of the grids is in contact with the dielectric. According to the present disclosure, the dielectric is configured as a grid framework of the ion grid structure, so that the mechanical strength of the grid is borne by the dielectric, thereby improving the mechanical strength of the ion grid structure and enhancing the stability and reliability of the ion grid structure.

As critical dimensions of semiconductor devices shrink and complexity of device fabrication processes increases, requirements on the IBE process become more stringent. In addition, stability and yield of semiconductor devices are directly correlated with uniformity of IBE within dimensions of silicon wafer samples. The uniformity of the IBE process is determined by performance of an IBE ion source, and more specifically, it is mainly related to the structural parameters of the IBE grid design.

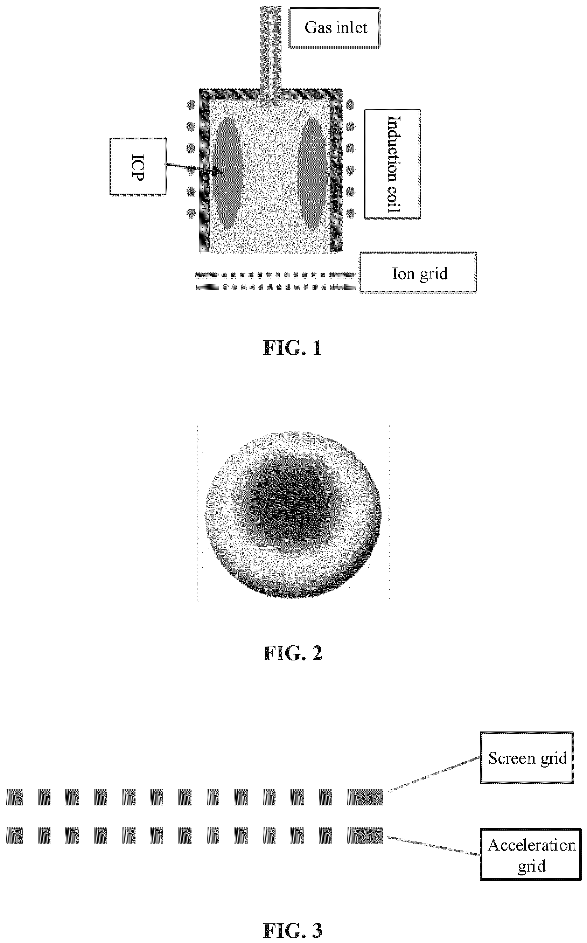

Currently, for a common ion source structure (as shown in FIG. 1), an inductive coupled plasma (ICP) is generated by applying a radio frequency (RF) current on a helical antenna on a discharge cavity. Initially generated plasma is primarily distributed within an elliptical area shown in FIG. 1. Under a low-pressure condition, a motion of the plasma within an ion source chamber approximately conforms to an ambipolar diffusion equation, and plasma density distribution along a radial direction generally follows Gaussian distribution (as shown in FIG. 2). That is, plasma density is highest at a center of coils and decreases radially with an increasing distance from the center. This poses significant challenges to achieving the uniformity required by the IBE process. Primary functions of the ion grid include extracting ions from an ion chamber and ensuring uniformity of extracted ion beams, making the ion grid a critical component for achieving IBE and ensuring uniformity of the IBE process.

Reference is made to FIG. 3, which is a schematic diagram of an ion grid structure for ion beam etching according to the conventional technology. The ion grid structure includes a screen grid and an acceleration grid, where the acceleration grid is arranged on a side of the screen grid away from a discharge chamber. In order to ensure uniformity in an etching process, an aperture of the grid corresponding to a center of a coil is set relatively small and an aperture of the grid corresponding to an area away from the center of the coil is set relatively large, thereby implementing extracting ion beams uniformly.

The screen grid is a grid layer closest to plasma in the ion chamber and is generally configured to operate at a positive potential. The acceleration grid is generally configured to operate at a negative potential. Such configuration serves two primary purposes: 1) providing an extraction voltage for positive ions, and 2) generating a large electrostatic barrier to prevent electrons generated by a neutralizer from flowing back to the ion chamber.

Typically, an ion source grid for IBE operates at a relatively low voltage in view of the fact that ions may cause ionization damage to the wafer. A high ion beam current density is required to ensure an etching rate and a uniform ion beam distribution is required to ensure etching uniformity. According to conventional theoretical researches, a maximum ion beam current that can be extracted through a single aperture is expressed as:

$$I1 = \frac{4\pi\varepsilon_0}{9}\sqrt{\frac{2e}{M}}V^{\frac{3}{2}}\frac{1}{1+4(\frac{l_g+t_s}{d_s})^2} \quad (1)$$

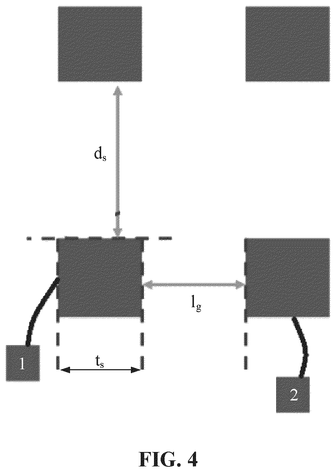

Reference is made to FIG. 4, which is a schematic diagram of key parameters of an ion grid structure for ion beam etching according to the conventional technology. As shown in FIG. 4, 1 represents a screen grid and 2 represents an acceleration grid.

I1 represents the ion beam current extracted through the single aperture of the ion grid structure, $\varepsilon_0$ represents a dielectric constant in vacuum, e represents a charge number of the ion beam, M represents an atomic mass of the ion beam, V represents an extraction voltage, that is, a voltage difference between the screen grid and the acceleration grid, $l_g$ represents a distance between the screen grid and the acceleration grid, $t_s$ represents a thickness of the screen grid, and $d_s$ represents an aperture of the screen grid.

By analyzing the theoretical equation (1), it can be seen that the ion beam current can be increased by: increasing the extraction voltage, increasing the aperture of the screen grid, reducing the distance between grids and reducing the thickness of the screen grid.

A case of increasing the extraction voltage to increase the ion beam current is described as follows. For the etching process, a voltage applied to the screen grid is typically a fixed value. The value determines final energy of particles bombarding a wafer surface, and a greater negative voltage applied to the acceleration grid causes greater bombardment energy of the ions that the acceleration grid is subjected to. In view of protecting the acceleration grid or reducing impurity particles, the increasing of the extraction voltage is limited. Therefore, the effect of increasing the extraction voltage to increase the ion beam current is limited.

In a case of reducing the distance between the grids to increase the ion beam current, the extracted ion beam current can be effectively increased by reducing the distance between the grids; however, a minimum distance between the grids is limited by a breakdown voltage of air, leading to a limited effect of reducing the distance between the grids to increase the ion beam current.

A case of reducing the thickness of the screen grid to increase the ion beam current is described as follows. In view of the fact that a thickness of a grid determines a mechanical strength of the grid and thus impairs the operating stability of the grid, especially when the grid is made of a special material, such as graphite that cannot be made extremely thin due to material properties, reducing the thickness of the screen grid to increase the extracted current is not feasible. In general, a three-layer grid structure is generally configured to increase an extracted ion current.

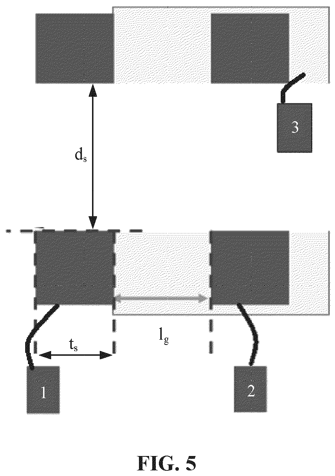

Therefore, in embodiments of the present disclosure, in order to further improve a capability of an ion grid structure to extract the ion beam current, key parameters of the ion grid structure are provided. Reference is made to FIG. 5, which is a schematic diagram of key parameters of an ion grid structure for ion beam etching according to an embodiment of the present disclosure.

The ion grid structure for ion beam etching provided in the embodiment of the present disclosure includes a screen grid 1 and one or more grids arranged on a side of the screen grid 1 away from a discharge chamber. It should be noted that the number of grids is not limited in the embodiment of the present disclosure, which may be determined by those skilled in the art according to actual requirements.

The screen grid 1 is contact with a dielectric 3 and at least one grid of the one or more grids is in contact with the dielectric 3. That is, according to the present disclosure, the dielectric 3 is configured as a grid framework of the ion grid structure, so that the mechanical strength of the grid is borne by the dielectric 3, thereby improving the mechanical strength of the ion grid structure and enhancing the stability and reliability of the ion grid structure.

In an embodiment, for example, the grid may be implemented by an acceleration grid 2. The acceleration grid 2 is arranged on a side of the screen grid 1 away from the discharge chamber, and the screen grid 1 is in contact with a side of the dielectric 3. The acceleration grid 2 is in contact with the dielectric 3. A distance between the screen grid 1 and the acceleration grid 2 is less than or equal to a first preset threshold. A thickness of the screen grid 1 is less than or equal to a second preset threshold.

In the embodiment according to the present disclosure, the dielectric 3 may be configured as the grid framework of the ion grid structure, so that the mechanical strength of the grid is borne by the dielectric. Thus, the thickness of the screen grid 1 is not a constraint on mechanical strength of the screen grid 1. In addition, the screen grid 1 is subjected to the least ion bombardment on the grid structure, where the bombardment is caused by approximately a dozen eV ions. Therefore, the thickness of the screen grid 1 can be set thin. Since a breakdown voltage of the dielectric 3 is large, a distance between the screen grid 1 and the acceleration grid 2 can be set less than the distance in a gas environment. The capability of the ion grid structure to extract the ion beam current is enhanced by reducing the thickness of the screen grid 1 and reducing the distance between the screen grid 1 and the acceleration grid 2.

According to existing researches, a breakdown voltage of air is approximately 3kV/mm, and a breakdown voltage of dielectric such as ceramics is approximately 14kV/mm. In theory, by using the dielectric, the distance between grids can be reduced compared with the distance in the gas environment.

In an embodiment of the present disclosure, the grid includes a deceleration grid (not shown in figures) arranged on a side of the acceleration grid 2 away from the screen grid 1. The deceleration grid is configured to decelerate the ion beam current to avoid excessive energy of the ion beam current bombarding the wafer.

In an embodiment of the present disclosure, the grid includes an extraction grid (not shown in figures) arranged between the screen grid 1 and the acceleration grid 2. The extraction grid is configured to extract an ion beam current from a discharge ion chamber.

In an embodiment of the present disclosure, the grid includes a focus grid (not shown in figures) between the extraction grid and the acceleration grid 2. The focus grid is configure to concentrate the ion beam current. In a case that a small beam spot size of the ion beam current is required, the focus grid focuses the ion beam current.

In an embodiment according to the present disclosure, at least one of the extraction grid, the focus grid, the acceleration grid 2 and the deceleration grid may be in contact with the dielectric 3, that is, in contact with an interior or a surface of the dielectric 3, and remaining grids may not be in contact with the dielectric 3, which is not limited in the embodiment of the present disclosure and may be determined by those skilled in the art according to actual requirements.

In an embodiment of the present disclosure, dielectric on the same side of the grid is provided with at least one type, that is, one or more types. Dielectric on different sides of the grid may also have at least one type, that is, one or more types. The number of types is not limited in the embodiment of the present disclosure and may be determined by those skilled in the art according to actual requirements.

For example, the dielectric between the screen grid 1 and the acceleration grid 2 is dielectric on the same side of the grid and may include multiple types of materials, such as alumina and quartz. The dielectric between the screen grid 1 and the acceleration grid 2 and dielectric between the acceleration grid 2 and the deceleration grid are on different sides of the grid (in this case, the dielectrics are on different sides of the acceleration grid 2). For example, the dielectrics include multiple types of materials, such as alumina and quartz.

In an embodiment of the present disclosure, the acceleration grid 2 may be arranged inside the dielectric 3, so that a distance between grids does not limit the mechanical strength of the grids. The arrangement of the acceleration grid 2 inside the dielectric 3 protects the acceleration grid 2, allowing a greater voltage change range of the acceleration grid 2 and thereby a greater withstand voltage of the grid.

In an embodiment of the present disclosure, the dielectric 3 is made of a material with a breakdown voltage greater than or equal to a third preset threshold, improving a withstand voltage of the grid.

In an embodiment, the dielectric 3 is made of an insulation material, and mechanical strength of the dielectric 3 is greater than or equal a fourth preset threshold. That is, the dielectric is made of an insulation material with a high mechanical strength, so as to improve the mechanical strength of the grid structure while ensuring insulation between grids.

In an embodiment of the present disclosure, the first preset threshold is 3mm and the second preset threshold is 5mm. That is, the distance between the screen grid 1 and the acceleration grid 2 may be set to 1/3 of a distance between grids in air dielectric, and the screen grid may be designed to be thin and overlaid on the dielectric 3.

In an embodiment of the present disclosure, the material of the dielectric 3 may include alumina, aluminum nitride, and/or quartz. The third preset threshold is 0.1kV/mm, that is, the dielectric 3 are made of the material with a high breakdown voltage.

In addition, the screen grid 1 and the acceleration grid 2 provided in the embodiments of the present disclosure are made of electrically conductive materials.

In an embodiment, electrical conductivity of the screen grid 1 and the grid is greater than the first preset value. Hardness of the screen grid 1 and the grid is greater than the second preset value. A coefficient of thermal expansion of the screen grid 1 and the grid is less than a third preset value. According to the embodiment of the present disclosure, the screen grid 1 and the grid are made of materials with high electrical conductivity, high hardness and a relatively low coefficient of thermal expansion.

For example, the material of the screen grid 1 includes molybdenum, graphite or the like. The material of the screen grid is not limited herein. It should be noted that the material of the screen grid excludes copper, so as to prevent potential contamination caused by copper.

A positive voltage is applied to the screen grid 1, and a negative voltage is applied to the acceleration grid 2. The deceleration grid is grounded. A voltage of the extraction grid is less than the voltage of the screen grid 1 and greater than the voltage of the acceleration grid 2. A voltage of the focus grid is less than the voltage of the extraction grid and greater than the voltage of the acceleration grid 2.

An ion grid structure for ion beam etching is provided according to the embodiments of the present disclosure. The ion grid structure includes a screen grid and one or more grids arranged on a side of the screen grid away from a discharge chamber. The screen grid is in contact with a dielectric, and at least one of the grids is in contact with the dielectric. According to the present disclosure, the dielectric is configured as a grid framework of the ion grid structure, so that the mechanical strength of the grid is borne by the dielectric, thereby improving the mechanical strength of the ion grid structure and enhancing the stability and reliability of the ion grid structure.

The embodiments in the present disclosure are described in a progressive manner, the same and similar parts of the various embodiments in this specification can be referred to each other, and each embodiment focuses on the differences from other embodiments.

The preferred embodiments according to the disclosure are disclosed above, and are not intended to limit the present disclosure. Those skilled in the art, without departing from the scope of the technical solutions of the present disclosure, may make variations and modifications to the technical solutions of the present disclosure based on the above disclosed method and technical solutions, or modify the embodiments to equivalent embodiments. Therefore, all simple modifications, equivalent changes and modifications made to the above embodiments based on the technical essence of the present disclosure without departing from the technical solutions of the present disclosure fall within the protection scope of the technical solutions of the present disclosure.

## Claims

1. An ion grid structure for ion beam etching, comprising:

   a screen grid and one or more grids, wherein the one or more grids are arranged on a side of the screen grid away from a discharge chamber, the screen grid is in contact with a dielectric; and at least one grid of the one or more grids is in contact with the dielectric.

2. The ion grid structure according to claim 1, wherein the one or more grids comprise:
   an acceleration grid arranged on a side of the screen grid away from the discharge chamber.

3. The ion grid structure according to claim 2, wherein a distance between the screen grid and the acceleration grid is less than or equal to a first preset threshold, and
   a thickness of the screen grid is less than or equal to a second preset threshold.

4. The ion grid structure according to claim 2, wherein the one or more grids comprise:
   a deceleration grid arranged on a side of the acceleration grid away from the screen grid.

5. The ion grid structure according to claim 2, wherein the one or more grids comprise:
   an extraction grid arranged between the screen grid and the acceleration grid.

6. The ion grid structure according to claim 5, wherein the one or more grids comprise:
a focus grid arranged between the extraction grid and the acceleration grid.

7. The ion grid structure according to any one of claims 1 to 6, wherein the dielectric arranged on a same side of the grid is provided with at least one type.

8. The ion grid structure according to any one of claims 1 to 6, wherein the dielectric arranged on different sides of the grid is provided with at least one type.

9. The ion grid structure according to claim 2, wherein the acceleration grid is arranged inside the dielectric.

10. The ion grid structure according to claim 1, wherein the dielectric is made of a material with a breakdown voltage greater than or equal to a third preset threshold.

11. The ion grid structure according to claim 10, wherein the dielectric is made of an insulation material.

12. The ion grid structure according to claim 10, wherein a mechanical strength of the dielectric is greater than or equal to a fourth preset threshold.

13. The ion grid structure according to claim 3, wherein the first preset threshold is 3mm and the second preset threshold is 5mm.

14. The ion grid structure according to claim 1, wherein a material of the dielectric comprises alumina, aluminum nitride and/or quartz.

15. The ion grid structure according to claim 11, wherein the third preset threshold is 0.1kV/mm.

16. The ion grid structure according to claim 2, wherein an ion beam current extracted through a single aperture of the ion grid structure is expressed as:

$$I1 = \frac{4\pi\varepsilon_0}{9}\sqrt{\frac{2e}{M}}V^{\frac{3}{2}}\frac{1}{1+4(\frac{l_g+t_s}{d_s})^2}$$

wherein I1 represents the ion beam current extracted through the single aperture of the ion grid structure, $\varepsilon_0$ represents a dielectric constant in vacuum, e represents a charge number of an ion beam, M represents an atomic mass of the ion beam, V represents an extraction voltage, $l_g$ represents a distance between the screen grid and the acceleration grid, $t_s$ represents a thickness of the screen grid, and $d_s$ represents an aperture of the screen grid.

17. The ion grid structure according to claim 1, wherein the screen grid and the one or more grids are made of electrically conductive materials.

18. The ion grid structure according to claim 17, wherein electrical conductivity of the screen grid and the one or more grids is greater than a first preset value.

19. The ion grid structure according to claim 17, wherein hardness of the screen grid and the one or more grids is greater than a second preset value.

20. The ion grid structure according to claim 17, wherein thermal expansion coefficients of the screen grid and the one or more grids are less than a third preset value.

21. The ion grid structure according to claim 2, wherein a positive voltage is applied to the screen grid and a negative voltage is applied to the acceleration grid.

22. The ion grid structure according to claim 4, wherein the deceleration grid is grounded.

23. The ion grid structure according to claim 5, wherein a voltage of the extraction grid is less than a voltage of the screen grid and greater than a voltage of the acceleration grid.

24. The ion grid structure according to claim 6, wherein a voltage of the focus grid is less than a voltage of the extraction grid and greater than a voltage of the acceleration grid.

**FIG. 1**

**FIG. 2**

**FIG. 3**

**FIG. 4**

**FIG. 5**

## INTERNATIONAL SEARCH REPORT

| International application No. |
|---|
| **PCT/CN2023/102689** |

### A. CLASSIFICATION OF SUBJECT MATTER

H01J37/147(2006.01)i; H01J37/30(2006.01)i

According to International Patent Classification (IPC) or to both national classification and IPC

### B. FIELDS SEARCHED

Minimum documentation searched (classification system followed by classification symbols)

IPC:H01J37/-

Documentation searched other than minimum documentation to the extent that such documents are included in the fields searched

Electronic data base consulted during the international search (name of data base and, where practicable, search terms used)

CNABS; CNTXT; WOTXT; EPTXT; USTXT; ENTXT; VEN; CNKI: 离子束, 栅网, 屏栅, 电极, 电介质, 绝缘, 陶瓷, ion beam, grid, screen grid, electrode, dielectric, insulate, ceramic

### C. DOCUMENTS CONSIDERED TO BE RELEVANT

| Category* | Citation of document, with indication, where appropriate, of the relevant passages | Relevant to claim No. |
|---|---|---|
| X | CN 105390356 A (LAM RESEARCH CORP.) 09 March 2016 (2016-03-09) description, paragraphs 2-104, and figures 1-7D | 1-24 |
| X | KR 20110097193 A (SUNGKYUNKWAN UNIVERSITY FOUNDATION FOR CORPORATE COLLABORATION) 31 August 2011 (2011-08-31) description, paragraphs 12-45, and figures 1-2 | 1-24 |
| X | KR 20100042303 A (SAMSUNG ELECTRONICS CO., LTD.) 26 April 2010 (2010-04-26) description, paragraphs 14-42, and figures 1-4 | 1-24 |
| A | US 4574179 A (UNIVERSITY OF TOKYO) 04 March 1986 (1986-03-04) entire document | 1-24 |
| A | JP 2003201957 A (MITSUBISHI ELECTRIC CORP.) 18 July 2003 (2003-07-18) entire document | 1-24 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **21 September 2023** | **26 September 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/102689**

| Patent document cited in search report | | | Publication date (day/month/year) | Patent family member(s) | | | Publication date (day/month/year) |
|---|---|---|---|---|---|---|---|
| CN | 105390356 | A | 09 March 2016 | KR | 20230043816 | A | 31 March 2023 |
| | | | | TW | 201626482 | A | 16 July 2016 |
| | | | | TWI | 686886 | B | 01 March 2020 |
| | | | | US | 2016064260 | A1 | 03 March 2016 |
| | | | | US | 9406535 | B2 | 02 August 2016 |
| | | | | KR | 20160026770 | A | 09 March 2016 |
| | | | | KR | 102514467 | B1 | 24 March 2023 |
| | | | | US | 2016307781 | A1 | 20 October 2016 |
| | | | | US | 9916993 | B2 | 13 March 2018 |
| | | | | US | 2018166304 | A1 | 14 June 2018 |
| | | | | US | 11062920 | B2 | 13 July 2021 |
| | | | | CN | 105390356 | B | 07 November 2017 |
| KR | 20110097193 | A | 31 August 2011 | | None | | |
| KR | 20100042303 | A | 26 April 2010 | | None | | |
| US | 4574179 | A | 04 March 1986 | EP | 0132015 | A2 | 23 January 1985 |
| | | | | EP | 0132015 | B1 | 09 August 1989 |
| | | | | DE | 3479363 | D1 | 14 September 1989 |
| | | | | CA | 1217532 | A | 03 February 1987 |
| | | | | JPS | 6020440 | A | 01 February 1985 |
| | | | | JPH | 0132627 | B2 | 07 July 1989 |
| JP | 2003201957 | A | 18 July 2003 | JP | 3906686 | B2 | 18 April 2007 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211558339